# EUROPÄISCHE PATENTANMELDUNG

(11) **EP 0 882 988 A2**
(43) Veröffentlichungstag der Anmeldung: **09.12.1998**
(21) Anmeldenummer: 98109512.8
(22) Anmeldetag: 26.05.1998
(51) Int. Cl.: G01P 15/12

(54) **Mikromechanisch hergestellter Verzögerungsschalter**

(30) Priorität: 05.06.1997 DE 19723522
(71) Anmelder: Daimler-Benz Aktiengesellschaft, 70567 Stuttgart (DE)
(72) Erfinder: Brambilla, Luigi, Dr., 71032 Böblingen (DE); Kaupp, Michael, 72160 Horb (DE); Müller, Manfred, 73779 Deizisau (DE); Rudolf, Harald, 72072 Tübingen (DE)

(57) **Zusammenfassung**

Die vorliegende Erfindung betrifft einen Verzögerungsschalter zur Detektion einer Fahrzeugverzögerung oberhalb eines bestimmten Schwellwertes, wobei der Verzögerungsschalter aus wenigstens einem FET-Transistor besteht, dessen bzw. deren Gate durch ein elektrisches Feld beeinflußt wird, das durch elektrische Ladungen auf einem Ladungsträger entsteht, wobei der Ladungsträger federnd aufgehängt ist, wobei infolge einer Auslenkung des Ladungsträgers wegen einer Verzögerung oberhalb des bestimmten Schwellwertes der Schaltzustand des bzw. der FET-Transistoren geändert wird, und wobei der Ladungsträger sowie dessen federnde Aufhängung mikromechanisch ausgebildet sind.

Alternativ kann ein Mikro-Permanentmagnet vorgesehen sein, die mikromechanisch aufgehängt ist und einen Hall-Geber ansteuert.

Eine weitere Alternative besteht aus einer beweglichen Lichtheitfaser, welche einen Phototransistor ansteuert.

Schliesslich kann der Detektor als mikromechanisch aufgehängte LED ausgebildet sein, welche zumindest zwei lichtempfindliche Flächen mit Fotowiderständen oder Fototransistoren ansteuert.

## Beschreibung

Die vorliegende Erfindung betrifft einen Verzögerungsschalter gemäß dem Oberbegriff des Patentanspruches 1, 2, 6 oder 7.

Es ist bereits bekannt, derartige Verzögerungsschalter in Steuergeräten als Teil einer Verzögerungssensorik zur Auslösung sicherheitsrelevanter Systeme im Falle eines Crashs eines Fahrzeuges vorzusehen. Derartige sicherheitsrelevante Systeme können beispielsweise Airbags sein, die immer weitere Verbreitung finden, oder auch sogenannte Gurtstrammer, die im Falle eines Crashs die Sicherheitsgurte straffen, um so eventuelle Submarining-Effekte zu vermeiden. Die Verzögerungssensorik umfaßt in der Regel einen Verzögerungsaufnehmer, dessen Signal aufbereitet und in der Weise bewertet wird, daß bei Überschreitung einer Schwelle eine Auslöseentscheidung herbeigeführt wird. Der Verzögerungsaufnehmer wirkt also als elektronischer Schalter und schaltet ab einem bestimmten Schwellwert der Verzögerung durch. Bauartbedingt weist dieser Verzögerungsaufnehmer eine entsprechend geringe Baugröße auf. Um ein unerwünschtes Auslösen beispielsweise infolge umgebungsbedingter elektromagnetischer Störungen zu vermeiden, ist neben dem Verzögerungsaufnehmer ein als mechanischer Schalter ausgebildeter Verzögerungsschalter vorgesehen. Eine Auslösung kann erst dann erfolgen, wenn sowohl der als mechanischer Schalter ausgebildete Verzögerungsschalter als auch der als elektronischer Schalter ausgebildete Verzögerungsaufnehmer geschaltet haben. Um im relevanten Bereich der Verzögerung die "Entscheidung" über die Auslösung der Sicherheitssysteme bei dem Verzögerungsaufnehmer zu belassen, ist der Schwellwert des Verzögerungsschalters entsprechend niedriger ausgelegt. Bei der bisherigen Ausbildung dieser Verzögerungsschalter haben diese einen relativ großen Bauraum ausgefüllt. Der Verzögerungsschalter schließt beispielsweise über Weicheisenkontakte, die mittels eines vorübergleitenden, gefederten Magneten als seismische Masse geschlossen werden. Es ist auch bekannt, andere bewegte und gefederte Massen vorzusehen, die als Rollen oder gleitende Blöcke mechanische Kontakte direkt schließen. Dieser Verzögerungsschalter wird auch als Hamlin-Schalter bezeichnet.

Es sind im einzelnen verschiedene Verzögerungsschalter bzw. Verzögerungsaufnehmer beschrieben.

Aus der DE 196 29 994 C1 ist es bekannt, einen Magneten mit einer Inertialmasse zu verbinden. Infolge einer Beschleunigung wird die Inertialmasse und damit der Magnet ausgelenkt, was mittels eines Reed-Schalters erfaßt wird.

Aus der DE 28 03 781 A1 ist ein Verzögerungsaufnehmer bekannt, bei dem eine Masse mit einem Federelement verbunden ist. Auf dem Federelement befindet sich ein Dehnmeßstreifen. Das Signal des Dehnmeßstreifens ändert sich in Abhängigkeit von der Auslenkung der Masse und damit der Längenänderung der Feder. Damit kann das Überschreiten eines Schwellwertes der Federkraft überwacht werden.

Aus der DE 94 15 257.8 U1 ist ein Näherungsschalter bekannt, bei dem das Magnetfeld eines Permanentmagneten zwei Hall-Sensoren durchsetzt. Wenn ein ferromagnetisches Auslöseelement in das Magnetfeld eingebracht wird, ändert sich die mittels der Hall-Sensoren erafßte magnetische Feldstärke. Je nach Position des Auslöseelementes werden mit dem Näherungsschalter verschiedene Schaltfunktionen ausgelöst.

Aus der DE 38 07 339 A1 ist ein Kipp- und Beschleunigungssensor bekannt, der eine Lichtschranke aufweist. Bei einer starken Verzögerung oder bei Überschreiten eines bestimmten Neigungswinkels fährt ein Element des Beschleunigungssensors durch den Weg des Lichtes von der Quelle zum Empfänger, so daß dies erkannt werden kann.

Es ist Aufgabe der vorliegenden Erfindung, einen Verzögerungsschalter in miniaturisierter Ausführungsform bereitszustellen, welcher gegenüber den bekannten Verzögerungsschaltern eine geringere Baugröße und ein geringeres Gewicht aufweist.

Demgegenüber besteht der erfindungsgemäße Verzögerungsschalter nach Anspruch 1 aus wenigstens einem FET-Transistor, dessen bzw. deren Gate durch ein elektrisches Feld beeinflußt wird, das durch elektrische Ladungen auf einem Ladungsträger entsteht, wobei der Ladungsträger federnd aufgehängt ist, wobei infolge einer Auslenkung des Ladungsträgers wegen einer Verzögerung oberhalb des bestimmten Schwellwertes der Schaltzustand des bzw. der FET-Transistoren geändert wird, und wobei der Ladungsträger sowie dessen federnde Aufhängung mikromechanisch ausgebildet sind.

Dadurch wird es vorteilhafterweise möglich, den Verzögerungsschalter mit dem Mikroprozessor und dem ASIC auf einem Chip zu integrieren.

Die mikromechanischen Komponenten können beispielsweise mittels der Röntgentiefenlithographie (LIGA) hergestellt werden unter Verwendung von geeigneten Abformmaterialien wie z.B. Polymethylmethaceylat (PMMA). Bei entsprechend großen Stückzahlen ist die Herstellung auch entsprechend günstig. Damit sind auch Konzepte realisierbar, bei denen Mechanik und Elektronik auf engstem Raum (µm-Bereich) miteinander verbunden sind.

Bei einer weiteren erfindungsgemäßen Lösung besteht der Verzögerungsschalter aus wenigstens einem Transistor, an dessen Steueranschluß eine Spannung eines Hallgebers anlegbar ist, wobei der bzw. die Hallgeber durch ein magnetisches Feld beeinflußt werden, das durch wenigstens einen Mikropermanentmagnet erzeugt wird, wobei der bzw. die Mikropermanentmagnete bzw. deren Träger federnd aufgehängt sind und wobei infolge einer Auslenkung des bzw. der Mikropermanentmagnete wegen einer Verzögerung oberhalb eines bestimmten Schwellwertes in den Hallgebern eine Hallspannung entsteht, die oberhalb der Steuerspannung des Transistors bzw. der Transistoren liegt, um diese in den durchgeschalteten Zustand zu bringen. Die Mikropermanentmagnete, deren Träger sowie deren Aufhängung sind mikromechanisch ausgebildet.

Bei dieser Lösung zeigen sich dieselben Vorteile hinsichtlich der Baugröße wie bei der Lösung nach Anspruch 1.

Bei dem Verzögerungsschalter nach Anspruch 3 ist die federnde Aufhängung durch Blattfedern realisiert.

Dabei zeigt sich vorteilhaft, daß diese Blattfedern durch entsprechenden Materialabtrag in einfacher Weise ausgebildet werden können.

Bei dem Verzögerungsschalter nach Anspruch 4 sind mehrere FET-Transistoren parallel geschaltet.

Dabei zeigt sich vorteilhaft, daß durch die Parallelschaltung auch größere Ströme geschaltet werden können.

Bei dem Verzögerungsschalter nach Anspruch 5 sind mehrere FET-Transistoren in Reihe geschaltet.

Dadurch kann die Ansprechsicherheit erhöht werden. Das bedeutet, daß bei einem eventuellen fehlerhaften Durchschalten eines Transistors das entsprechende System noch nicht ausgelöst werden kann.

Bei dem Verzögerungsschalter zur Detektion einer Fahrzeugverzögerung oberhalb eines bestimmten Schwellwertes gemäß Anspruch 6 besteht der Verzögerungsschalter aus wenigstens einem Phototransistor, dessen lichtempfindlicher Basis zumindest ein Ende eines mikromechanischen Lichtleiters zugeordnet ist derart, daß bei einer Verzögerung oberhalb eines bestimmten Schwellwertes durch eine Veränderung der Lage des Lichtleiters über den Lichtleiter Licht an die Basis des Phototransistors geführt wird.

Beispielsweise kann der Lichtleiter kammartig ausgebildet sein, wobei die Veränderung der Lage des Lichtleiters als Verbiegung der Enden des Kammes realisiert sein kann. Die "federnde Aufhängung" im Vergleich zu den anderen beschriebenen Lösungen wird hier durch die Elastizität des Materiales bewirkt.

Bei dem Verzögerungsschalter zur Detektion einer Fahrzeugverzögerung oberhalb eines bestimmten Schwellwertes nach Anspruch 7 besteht der Verzögerungsschalter aus wenigstens einer LED, die in mehreren Raumrichtungen mikromechanisch federnd aufgehängt ist. Weiterhin sind dieser LED unterschiedliche lichtempfindliche Flächen zugeordnet derart, daß bei einer Auslenkung der LED infolge einer Verzögerung oberhalb eines Schwellwertes die LED eine andere Fläche anleuchtet als im Ruhezustand.

Dadurch kann insbesondere die Verzögerung in verschiedenen Richtungen, wie beispielsweise in Längs- und Querrichtung überwacht werden.

Bei allen diesen erfindungsgemäßen Lösungen ergibt sich eine ausgeprägte verzögerungsabhängige Schaltcharakteristik wie bei den bekannten mechanischen Sicherheitsschalterns sowie eine geringere Empfindlichkeit gegenüber elektrischen Störeinflüssen. Gegenüber den bekannten Hamlin-Schaltern ergibt sich eine geringere Baugröße und ein geringeres Gewicht.

In der Regel bildet der erfindungsgemäße Verzögerungsschalter - in Ersetzung des konventionellen mechanischen Verzögerungsschalters - gemeinsam mit einem Verzögerungsaufnehmer eine Verzögerungssensorik. Es ist jedoch auch denkbar, den erfindungsgemäßen Verzögerungsschalter allein als Verzögerungssensorik zur Auslösung sicherheitsrelevanter Systme vorzusehen.

Ein Ausführungsbeispiel der Erfindung ist in der Zeichnung näher dargestellt. Es zeigt dabei im einzelnen:
- Fig. 1:: ein Ausführungsbeispiel der Erfindung und
- Fig. 2 bis 4:: Ausführungsbeispiele anderer Lösungen.

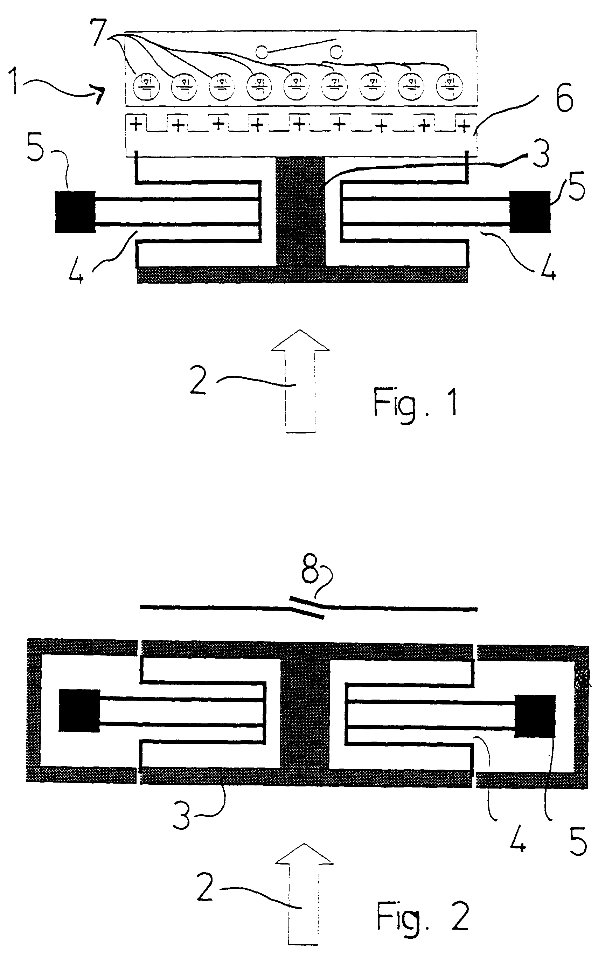

Figur 1 zeigt die Anbringung eines Verzögerungsschalters 1 relativ zur Fahrtrichtung, die durch den Pfeil 2 dargestellt wird. Eine seismische Masse 3 ist über Blattfedern 4 mit dem Fahrzeug verbunden. Dabei sind die Fußpunkte 5 der Blattfedern 4 fahrzeugfest angebracht. Bei einer Verzögerung des Fahrzeuges wird die seismische Masse in Fahrtrichtung, d.h. in Richtung des Pfeiles 2 ausgelenkt. Die seismische Masse 3 weist einen kammartigen Ladungsträger 6 auf. Bei einer entsprechenden Auslenkung der seismischen Masse 3 infolge der Fahrzeugverzögerung wird dieser Ladungsträger 6 derart bewegt, daß durch das elektrische Feld um diesen Ladungsträger 6 die Gates der FET-Transistoren 7 derart beeinflußt werden, daß diese FET-Transistoren 7 durchschalten. Dabei wird der Verzögerungsschalter 1 so dimensioniert, daß eine solche Beeinflussung erst bei Überschreiten des Schwellwertes der Verzögerung möglich ist.

Die FET-Transistoren 7 sind dabei selbstsperrende n-Kanal IG-FET's. Ab dem Schaltpunkt läßt die positive Ladung des kammartigen Ladungsträgers 6 in den FET-Transistoren negative Ladungen in der Verarmungszone entstehen. Damit werden die einzelnen Transistoren leitend. Aufgrund deren Parallelschaltung kann dann ein hoher Strom fließen.

Wie eingangs bereits beschrieben kann die Herstellung der Blattfedern aus PMMA (Polymethylmethacryalat) unter Verwendung der Röntgentiefenlithografie (LIGA) erfolgen. Dadurch kann der Verzögerungsschalter mit geringer Baugröße hergestellt werden und mit dem ASIC bzw. dem Mikroprozessor auf einem Chip integriert werden.

Eine andere Ausgestaltung im Rahmen der Erfindung ergibt sich, wenn anstelle der FET-Transistoren Transistoren Verwendung finden, deren Steueranschluß mit einem Hallgeber verbunden ist, und anstelle des Ladungsträgers 6 ein Träger Verwendung findet, auf dem Mikropermanentmagnete angeordnet sind. Bei einer Fahrzeugverzögerung werden diese Mikropermanentmagnete entsprechend ausgelenkt. Die Hallgeber sind ortsfest am Fahrzeug befestigt. Die Auslenkung der Mikropermanentmagnete bewirkt eine Änderung des Magnetfeldes der Hallgeber. Bei einer geeigneten Auslegung des Verzögerungsschalters kann die resultierende Hallspannung oberhalb der Steuerspannung liegen, bei der die Transistoren in den durchgeschalteten Zustand übergehen. Auch mit einer solchen Lösung ist eine mikromechanische Realisierung eines Verzögerungsschalters denkbar.

Weitere mikromechanische Lösungen werden im Zusammenhang mit den nachfolgenden Figuren 2 bis 4 erläutert.

Figur 2 zeigt einen magnetischen Kontaktschalter als Verzögerungsschalter. Dabei hängt der Magnet als seismische Masse 3 an Blattfedern 4.

Aus Stabilitätsgründen können diese mit einem großen Aspektverhältnis (Verhältnis der Strukturhöhe zur lateralen Ausdehung) ausgebildet sein. Die freie Beweglichkeit der Blattfedern wird mit der Opferschichttechnik erzeugt. Diese einzelnen Merkmale der Ausführung der Blattfedern erweisen sich auch vorteilhaft bei den Blattfedern der anderen Ausführungsbeispiele.

Bei einer einwirkenden Verzögerung bewegt sich die seismische Masse aus magnetischem Material auf die weichmagnetischen Kontakte zu, erzeugt dort in den Enden jeweils magnetische Nord- und Südpole und schließt die Kontakte. Ein magnetischer Streufluß in der Ausgangslage wird durch seitliche Jochpaare verhindert. Der Kontakt 8 ist dann geschlossen.

Auch hier wird die seismische Masse und deren federnde Aufhängung vorteilhaft in LIGA-Technik hergestellt.

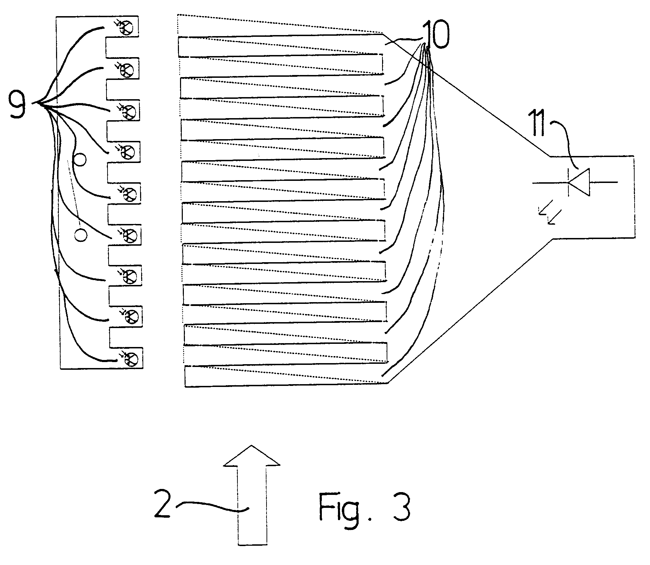

Figur 3 zeigt die optoelektronische Ausführung eines mikromechanischen Verzögerungsschalters 1. Als eigentlicher Schalter werden parallelgeschaltete Fototransistoren 9 benutzt. Durch die Parallelschaltung kann ein hoher Nutzstrom geführt werden. Gegenüber der fotoempfindlichen Basis der Transistoren 9 befindet sich ein lichtleitender, beweglicher Kamm 10 aus PMMA. Der PMMA-Kamm 10 wird mit Licht aus einer oder mehreren LED's 11 versorgt. Da dieser Kamm 10 aber zunächst versetzt angeordnet ist, trifft das Licht die Fototransistoren 9 zunächst nicht.

Grundsätzlich ist es möglich, in dieser Stellung weitere Fototransistoren anzuordnen, um die Funktionsfähigkeit des lichtleitenden Kammes 10 zu überprüfen.

Die Enden des Kammes 10 stellen gleichzeitig die seismische Masse dar. Bei einer einwirkenden Fahrzeugverzögerung werden die Kammenden in Richtung des Pfeiles 2 in die punktiert gezeichnete Stellung ausgelenkt und die Fototransistoren 9 werden durch die einsetzende Lichtwirkung angesteuert. Der aus den parallel angeordneten Transistoren 9 bestehende Verzögerungsschalter 1 schließt.

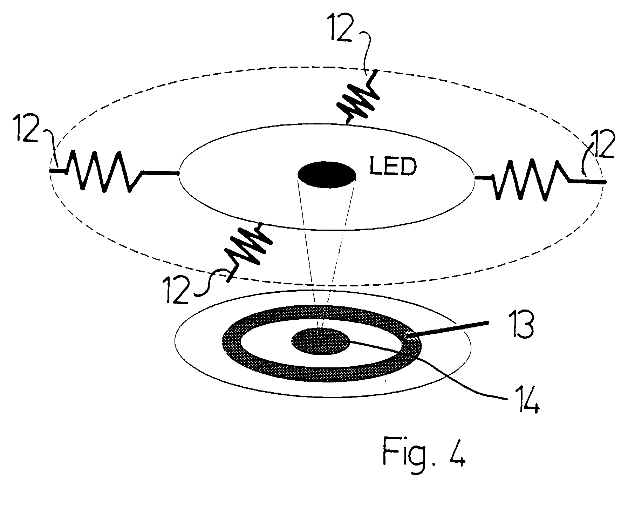

Figur 4 zeigt ein Ausführungsbeispiel eines omnidirektionalen Verzögerungsschalters 1. Ein solcher Verzögerungsschalter kann auch bei Seitenunfällen oder bei Heckcrashs ansprechen. Eine mit mikromechanischen Federelementen 12 gelagerte LED leuchtet auf eine darunterliegende Ebene. Liegt eine Beschleunigung bzw. Verzögerung an, wird der Lichtkegel aus der Mitte herausbewegt und trifft eine fotoempfindliche Schicht 13, die aus Fotowiderständen oder aus Fototransistoren bestehen kann. Diese Erregung kann dazu verwendet werden, als Trigger weitere elektronische Schalter anzusteuern, die danach für eine gewisse Zeit geschlossen bleiben. Diese Anordnung läßt sich zudem leicht überprüfen, wenn man einen kleinen Ring 14 integriert, der bei normalen Fahrereignissen (wie z.B. Beschleunigen und Bremsen im Bereich 0,5g bis 1g) anspricht.

## Patentansprüche

1. Verzögerungsschalter (1) zur Detektion einer Fahrzeugverzögerung oberhalb eines bestimmten Schwellwertes, der insbesondere gemeinsam mit einem Verzögerungsaufnehmer eine Verzögerungssensorik bildet,
dadurch gekennzeichnet, daß der Verzögerungsschalter (1) aus wenigstens einem FET-Transistor (7) besteht, dessen bzw. deren Gate durch ein elektrisches Feld beeinflußt wird, das durch elektrische Ladungen auf einem Ladungsträger (6) entsteht, daß der Ladungsträger (6) federnd aufgehängt ist, daß infolge einer Auslenkung des Ladungsträgers (6) wegen einer Verzögerung oberhalb des bestimmten Schwellwertes der Schaltzustand des bzw. der FET-Transistoren (7) geändert wird, und daß der Ladungsträger (6) sowie dessen federnde Aufhängung (4) mikromechanisch ausgebildet sind.

2. Verzögerungsschalter (1) zur Detektion einer Fahrzeugverzögerung oberhalb eines bestimmten Schwellwertes, der insbesondere gemeinsam mit einem Verzögerungsaufnehmer eine Verzögerungssensorik bildet,
dadurch gekennzeichnet, daß der Verzögerungsschalter (1) aus wenigstens einem Transistor besteht, an dessen Steueranschluß eine Spannung eines Hallgebers anlegbar ist, wobei der bzw. die Hallgeber durch ein magnetisches Feld beeinflußt werden, das durch wenigstens einen Mikropermanentmagnet erzeugt wird, daß der bzw. die Mikropermanentmagnete oder deren Träger federnd aufgehängt sind und daß infolge einer Auslenkung des bzw. der Mikropermanentmagnete wegen einer Verzögerung oberhalb eines bestimmten Schwellwertes in den Hallgebern eine Hallspannung entsteht, die oberhalb der Steuerspannung des Transistors bzw. der Transistoren liegt, um diese in den durchgeschalteten Zustand zu bringen und daß die Mikropermanentmagnete, deren Träger sowie deren Aufhängung mikromechanisch ausgebildet sind.

3. Verzögerungsschalter nach Anspruch 1 oder 2,
dadurch gekennzeichnet, daß die federnde Aufhängung (4) durch Blattfedern realisiert ist.

4. Verzögerungsschalter nach einem der Ansprüche 1 bis 3,
dadurch gekennzeichnet, daß mehrere Transistoren (7) parallel geschaltet sind.

5. Verzögerungsschalter nach einem der Ansprüche 1 bis 3,
dadurch gekennzeichnet, daß mehrere Transistoren (7) in Reihe geschaltet sind.

6. Verzögerungsschalter (1) zur Detektion einer Fahrzeugverzögerung oberhalb eines bestimmten Schwellwertes, der insbesondere gemeinsam mit einem Verzögerungsaufnehmer eine Verzögerungssensorik bildet,
dadurch gekennzeichnet, daß der Verzögerungsschalter (1) aus wenigstens einem Phototransistor (9) besteht, dessen lichtempfindlicher Basis zumindest ein Ende eines mikromechanischen Lichtleiters zugeordnet ist derart, daß bei einer Verzögerung oberhalb eines bestimmten Schwellwertes durch eine Veränderung der Lage des Lichtleiters über den Lichtleiter Licht an die Basis des Phototransistors (9) geführt wird.

7. Verzögerungsschalter (1) zur Detektion einer Fahrzeugverzögerung oberhalb eines bestimmten Schwellwertes, der insbesondere gemeinsam mit einem Verzögerungsaufnehmer eine Verzögerungssensorik bildet,
dadurch gekennzeichnet, daß der Verzögerungsschalter (1) aus wenigstens einer LED besteht, die in mehreren Raumrichtungen mikromechanisch federnd aufgehängt ist (12) und daß dieser LED unterschiedliche lichtempfindliche Flächen (13 und 14) zugeordnet sind derart, daß bei einer Auslenkung der LED infolge einer Verzögerung oberhalb eines Schwellwertes die LED eine andere Fläche (13) anleuchtet als im Ruhezustand (Fläche 14).
